# EUROPEAN PATENT APPLICATION

(11) **EP 2 398 008 A1**
(43) Date of publication of application: **21.12.2011**
(21) Application number: 09840044.3
(22) Date of filing: 01.12.2009
(51) Int. Cl.: G09F 9/30, G02F 1/1345, H05K 1/09, H05K 1/11

(54) **CONNECTION TERMINAL AND DISPLAY DEVICE WITH THE CONNECTION TERMINAL**

(30) Priority: 10.02.2009 JP 2009028829
(71) Applicant: Sharp Kabushiki Kaisha, Osaka-shi, Osaka 545-8522 (JP)
(72) Inventor: KITOH, Kenichi, Osaka 545-8522 (JP); NAKAMURA, Wataru, Osaka 545-8522 (JP); TANAKA, Tetsunori, Osaka 545-8522 (JP); HARA, Takeshi, Osaka 545-8522 (JP); NAKANO, Yuya, Osaka 545-8522 (JP)
(74) Representative: Hoffmann, Jörg Peter
(86) International application number: PCT/JP2009/070194
(87) International publication number: WO 2010/092725

(57) **Abstract**

A connecting terminal has a configuration in which a plurality of parts of a first line (2) and respective corresponding plurality of parts of a second line (6) are connected to each other by a transparent conductive thin film (10). In a connecting terminal part, the plurality of parts of the first line (2) and the respective corresponding plurality of parts of the second line (6) are connected to each other in parallel. With the configuration, it is possible to greatly reduce a risk of disconnection. It is therefore possible to prevent disconnection from being caused by corrosion in the connecting terminal part of a display apparatus etc.

## Description

### Technical Field

The present invention relates to a display apparatus such as a liquid crystal display apparatus, an organic EL display apparatus, an inorganic display apparatus, and an electrophoresis display apparatus. The present invention particularly relates to a connecting terminal suitable for connecting of the display apparatus to an external circuit and to a display apparatus including the connecting terminal.

### Background Art

Display apparatuses such as an active matrix liquid crystal display apparatus have a configuration described as follows. Generally, a plurality of scanning electrodes and a plurality of signal electrodes are provided in matrix in a display region of a substrate constituting a display apparatus, and a switching device like a thin film transistor and a pixel electrode are provided at and for each of intersections of the plurality of scanning electrodes and the plurality of signal electrodes. The plurality of scanning electrodes are drawn out to a connecting terminal provided outside the display region, so as to be connected to an external circuit such as a driver circuit via the connecting terminal. Likely, the plurality of signal electrodes are drawn out to a connecting terminal provided outside the display region, so as to be connected to an external circuit such as a driver circuit via the connecting terminal.

In the active matrix liquid crystal display apparatus, the increased number of display pixels inevitably necessitates the increased number of lines. In liquid crystal display apparatuses, however, line portions are portions not directly contributing to display. Thus, for realization of a display apparatus allowing for bright display, it is preferable to reduce an area of the line portions as small as possible. The reduction in the area of the line portions may be achieved by narrowing widths of the lines. However, the lines with the narrowed widths have increased resistances. Thus, it becomes impossible to supply required electricity to each of the pixels.

In view of such circumstances, copper (Cu) with a low resistivity or a copper alloy have been used as a material of the lines. However, copper (Cu) has a property that it is vulnerable to moisture and easily corroded by moisture in an atmosphere.

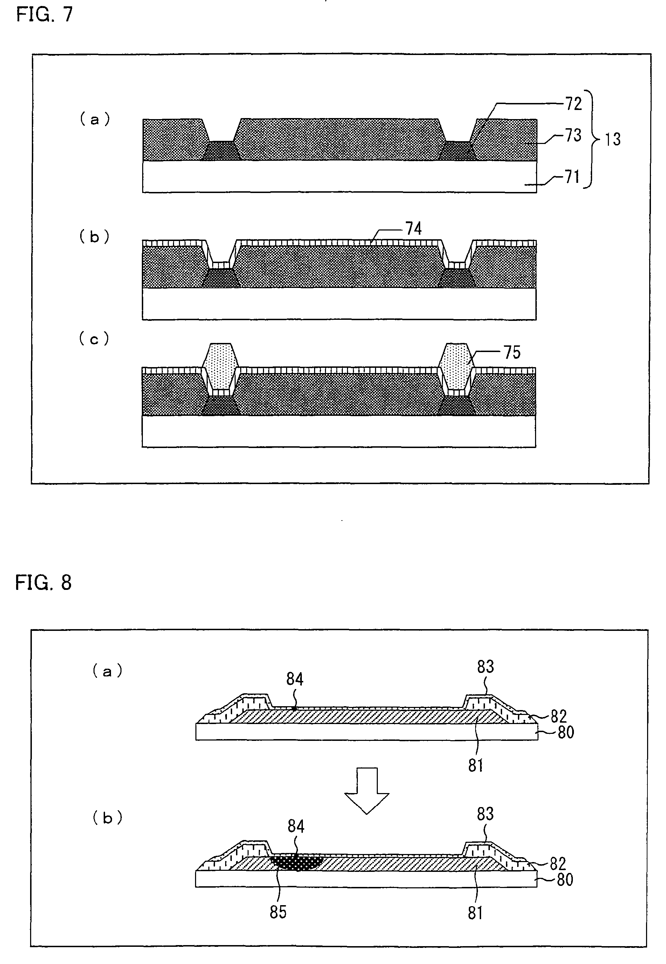

(a) and (b) of Fig. 8 are views each showing a connecting terminal part in a configuration where copper is used as a line material. In (a) and (b) of Fig. 8, 80 indicates a substrate made from glass or the like. A line layer 81 made from copper (Cu) is provided on the substrate 80. Generally, a base layer made from titanium (Ti), a titanium alloy, molybdenum (Mo), a molybdenum alloy, or the like is provided at first, and then a Cu layer is provided on the base layer, in view of improving an adhesiveness to the glass or the like and improving a barrier property. A detailed description of a structural aspect is omitted herein. The Cu line layer is extended to a display region where TFTs etc. are provided, so as to be connected to the TFTs etc. provided there.

The line layer 81 is covered by an insulating layer 82. However, a part of the insulating layer 82 is removed at a site which forms the connecting terminal. Therefore, the line layer 81 is exposed at this site for electric connection with the external circuit or the like. The line layer 81 and the insulating layer 82 are further covered by a transparent electrode material 83 such as ITO. A film, which is formed at the same time as pixel electrodes in the display region are formed, can be used as the transparent electrode material 83 in a connection region where the electric connection to the external circuit or the like is made. This eliminates the need for a particular step for forming the transparent electrode material 83 in the connection region.

In a case where the transparent electrode material 83 is provided without having any defect, there will be no problem. However, in a case where the transparent electrode material 83 has a defect such as a pinhole 84 (see (a) of Fig. 8), moisture in the air enters the line layer 81 via the pinhole 84 and eventually causes a corrosion part 85 shown in (b) of Fig. 8. In the worst case, the corrosion part 85 spreads over the entire line layer 81 and thereby causes disconnecting of the line layer 81. As early described, the transparent electrode material 83 is provided at the same time as the pixel electrode is provided. Since it is necessary that the pixel electrode part secures light transmittance of a given level or greater, a thickness of the transparent electrode material 83 cannot be thickened freely. Further, there is a tendency that, as the number of pixels is increased, a TCP (Tape Carrier Package) has smaller pitches. As such, widths of the connecting terminals are decreased. In such circumstances, a risk that the connecting terminal part is corroded to be disconnected is further increased, and any sort of a countermeasure is desired.

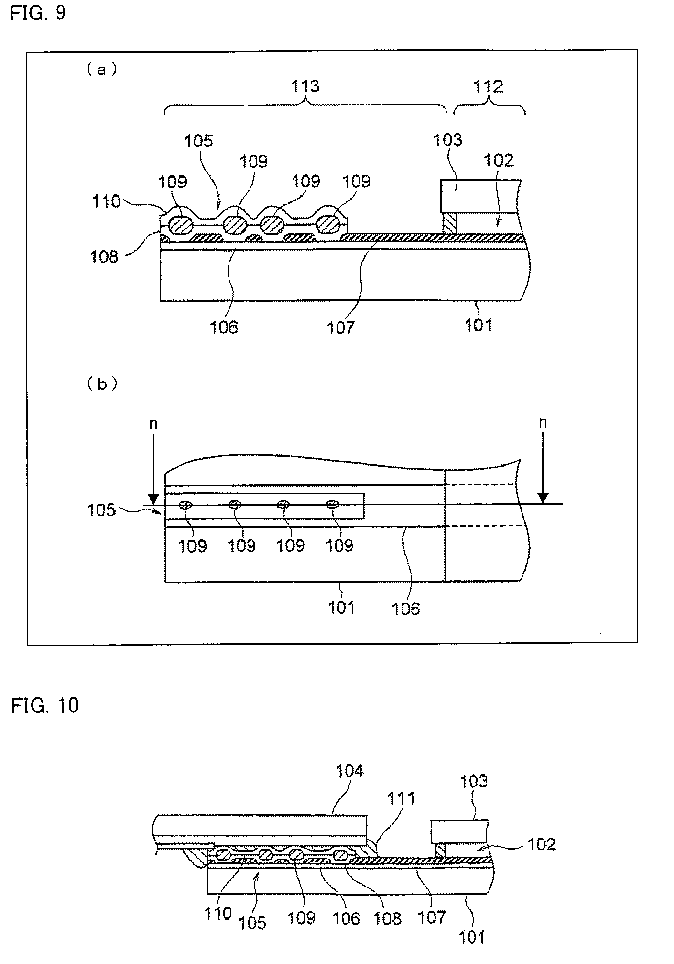

Patent Literature 1 describes a technique for preventing a connecting terminal from being corroded due to moisture in the air. (a) and (b) of Fig. 9 and Fig. 10 are views each showing a terminal part of Patent Literature 1 for external connection. (a) of Fig. 9 is a cross sectional view taken on a line (n-n) in (b) of Fig. 9, whereas (b) of Fig. 9 is a plan view of (a) of Fig. 9. Fig. 10 is a diagram showing a configuration in which a TCP (Tape Carrier Package) 104 is connected to the terminal part.

In (a) and (b) of Fig. 9, 101 and 103 indicate respective substrates that form up a pair. For example, a substrate 101 is made in the form of an active matrix substrate in which switching devices are provided, whereas a substrate 103 is made in the form of a counter substrate in which a color filter etc. are provided. Line layers such as gate lines and signal lines are provided in the substrate 101. The line layers are connected to a metal line 106 and drawn out to a connecting terminal 105 provided in a surrounding region 113 around a display region 112.

The connecting terminal 105 is formed as follows. At first, an insulator 107, which is deposited on the metal line 106 provided for drawing out the line layers, is removed by a photolithography technique so that a predetermined pattern having a plurality of contact holes is formed in the insulator 107. This causes a part of the metal line 106 to be exposed. Then, a first conductive film 108 is adhesively deposited. This causes the metal line 106 and the first conductive film 108 to be electrically connected to each other via the plurality of contact holes. Subsequently, insulators 109 are formed for the respective plurality of the contact holes on the first conductive film 108, so as to cover the respective plurality of contact holes from the above. After this, a second conductive film 110 is adhesively deposited on the first conductive film 108 and the insulators 109.

In the connecting terminal 105 shown in (a) and (b) of Fig. 9, the insulator 109 caps a "contact hole part via which the metal line 106 for drawing out the line layers is exposed from the insulator 107". This keeps out moisture from a connecting part between the metal line 106 and the first conductive film 108.

Fig. 10 shows a state that a TCP (Tape Carrier Package) 104 is connected to the connecting terminal 105. For example, the connecting of the TCP to the connecting terminal 105 is carried out by using an anisotropic conductive adhesive agent 111 prepared by dispersing conductive particles in a thermosetting resin. Note that, in Fig. 10, members identical with members shown in (a) and (b) of Fig. 9 are given identical reference numerals, and their detailed descriptions are omitted.

### Citation List

### Patent Literature 1

Japanese Patent Application Publication, Tokukai, No. 2005-321707 A (Publication Date: November 17, 2005)

### Summary of Invention

### Technical Problem

However, the aforementioned conventional technique poses a problem described as follows. Specifically, for improvements in a waterproof property and a humidity resistance, it is necessary to provide the insulator 109 so as to cap with accuracy the contact hole part in the insulator 107. This constitutes a barrier to manufacturing of a reliable connecting terminal. Note that it is considered that, in a case where the size of a capping insulator is slightly greater than the contact hole, it is possible to prevent any adverse influence even if the capping insulator is somewhat displaced. However, there is still a problem described as follows. Specifically, in a case where the connecting terminal, which is drawn out from the pixel part for the connection to the external circuit, is made up of a single layer and has a defect such as a pinhole, there is a risk that disconnection occurs. There is also another problem related to a configuration of the connecting terminal. Specifically, since the metal line 106 and the first conductive film 108 are directly connected to each other, there is a risk that, in a case where metal corrosion occurs, it is impossible to prevent its progression and eventually a disconnection occurs.

The present invention was made in view of the problems, and an object of the present invention is to provide (i) a connecting terminal, which has a lower risk of disconnection by moisture etc. in the air even in a case of employing a thin film made from a highly conductive but poorly moisture-resistant material, such as copper (Cu), and (ii) a display apparatus employing the connecting terminal.

### Solution to Problem

In order to attain the object, a connecting terminal of the invention of the present application is a connecting terminal in a substrate of a display apparatus including (i) a lower layer line and (ii) an upper layer line located above the lower layer line via an insulating layer, via which connecting terminal the lower layer line and the upper layer line are connected to an outside the substrate of the display apparatus, a transparent pixel electrode being driven via the lower layer line, the lower layer line and the upper layer line being connected to each other via a transparent conductive thin film constituting the transparent pixel electrode.

According to the configuration, the connecting terminal has a tri-layer structure including the lower layer line, the upper layer line, and the transparent conductive thin film. This can reduce a risk of disconnection. With the configuration, it is therefore possible to provide the connecting terminal which is highly reliable.

For a fuller understanding of the nature and advantages of the invention, reference should be made to the ensuing detailed description taken in conjunction with the accompanying drawings.

### Advantageous Effects of Invention

As early described, a connecting terminal of the invention of the subject application is a connecting terminal in a substrate of a display apparatus including (i) a lower layer line and (ii) an upper layer line located above the lower layer line via an insulating layer, via which connecting terminal the lower layer line and the upper layer line are connected to an outside the substrate of the display apparatus, the transparent pixel electrode being driven via the lower layer line, the lower layer line and the upper layer line being electrically connected to each other via a transparent conductive thin film constituting a transparent pixel electrode.

With the configuration, it is possible to greatly reduce a risk of disconnection in the connecting terminal part of the display apparatus.

### Brief Description of Drawings

Fig. 1

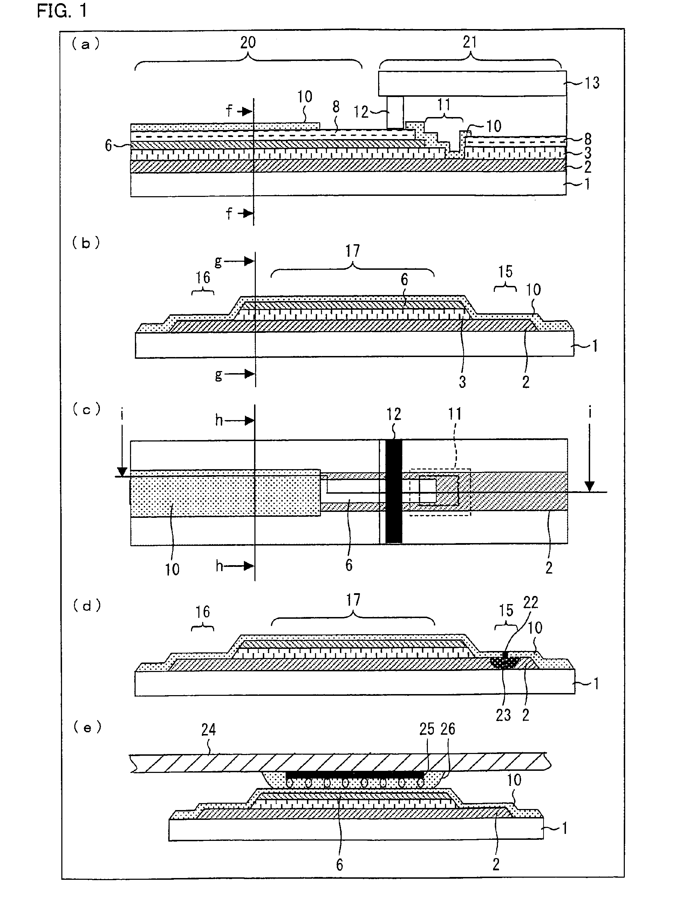

   Fig. 1 is a drawing showing a connecting terminal part of Example 1 of the present invention.
Fig. 2

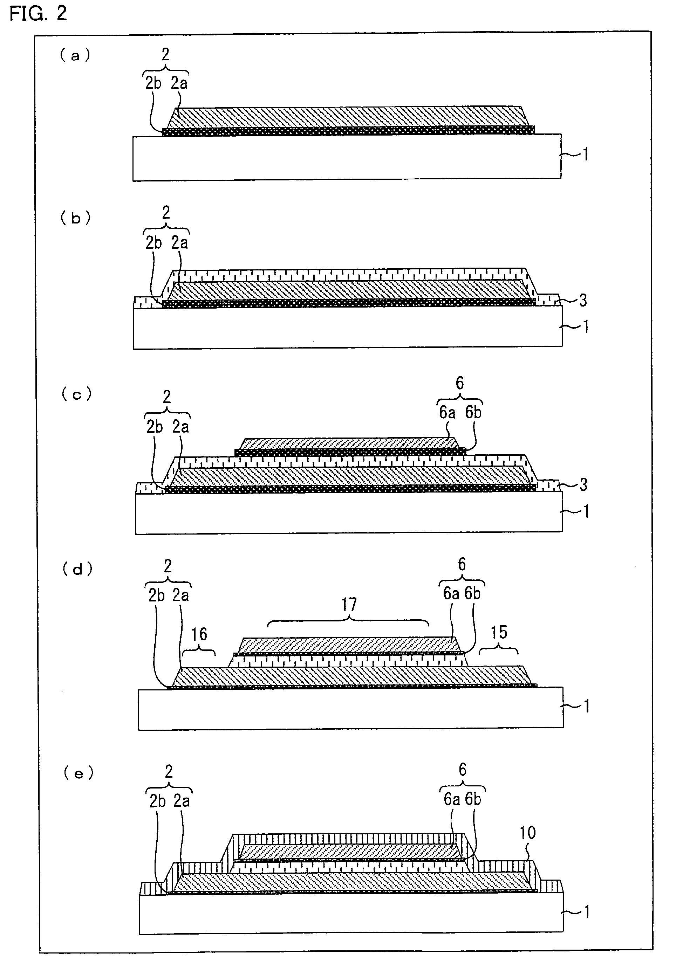

   Fig. 2 is a drawing showing a method for manufacturing a connecting terminal of Example 1 of the present invention.
Fig. 3

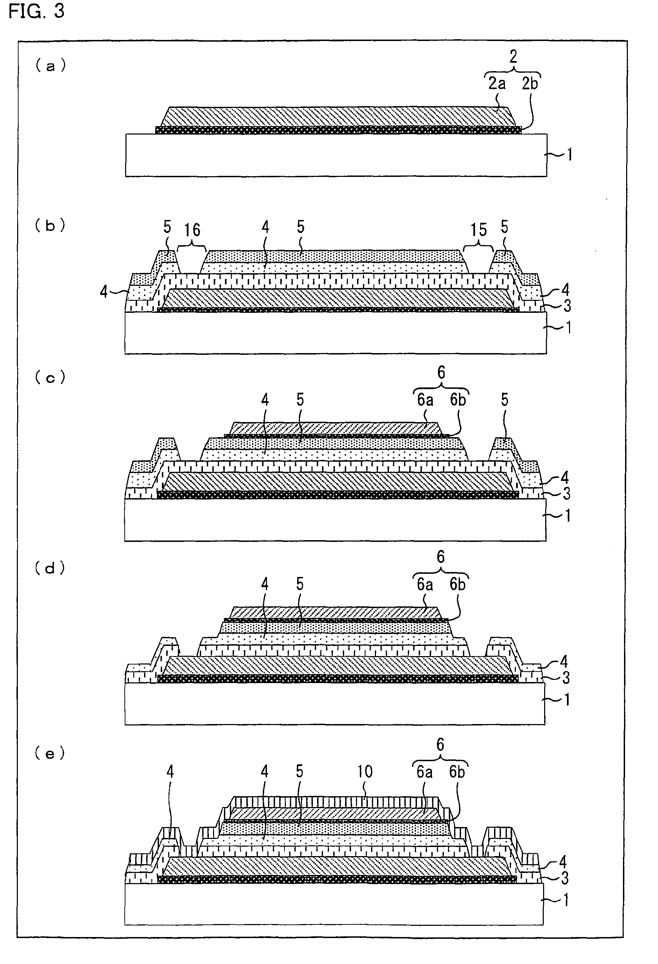

   Fig. 3 is a drawing showing (i) how a connecting terminal of Example 2 of the present invention is configured and (ii) a method for manufacturing the connecting terminal of Example 2 of the present invention.
Fig. 4

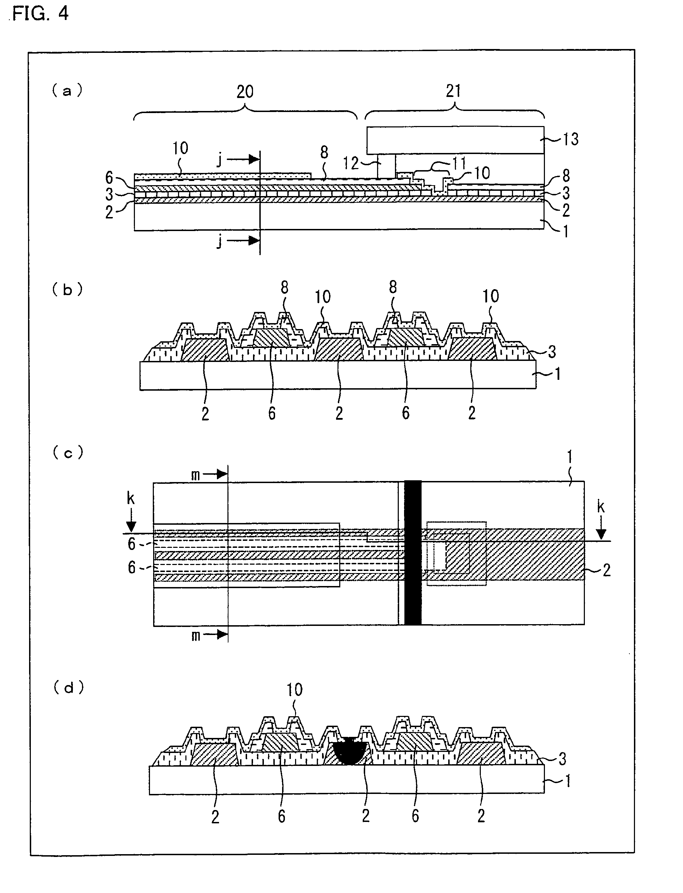

   Fig. 4 is a drawing showing (i) how a connecting terminal of Example 3 of the present invention is configured and (ii) a method for manufacturing the connecting terminal of Example 3 of the present invention.
Fig. 5

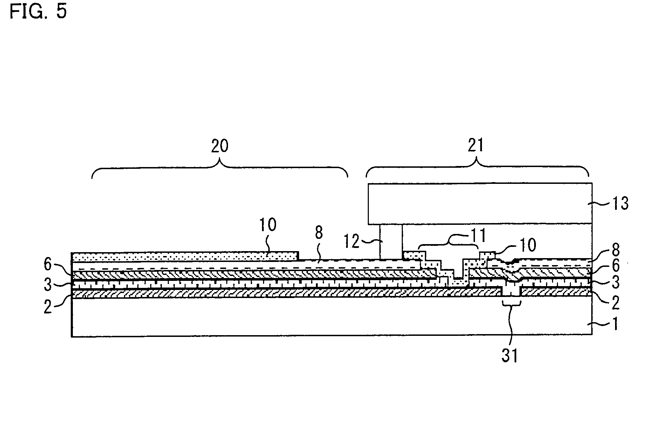

   Fig. 5 is a drawing showing how a connecting terminal of Example 4 of the present invention is configured.
Fig. 6

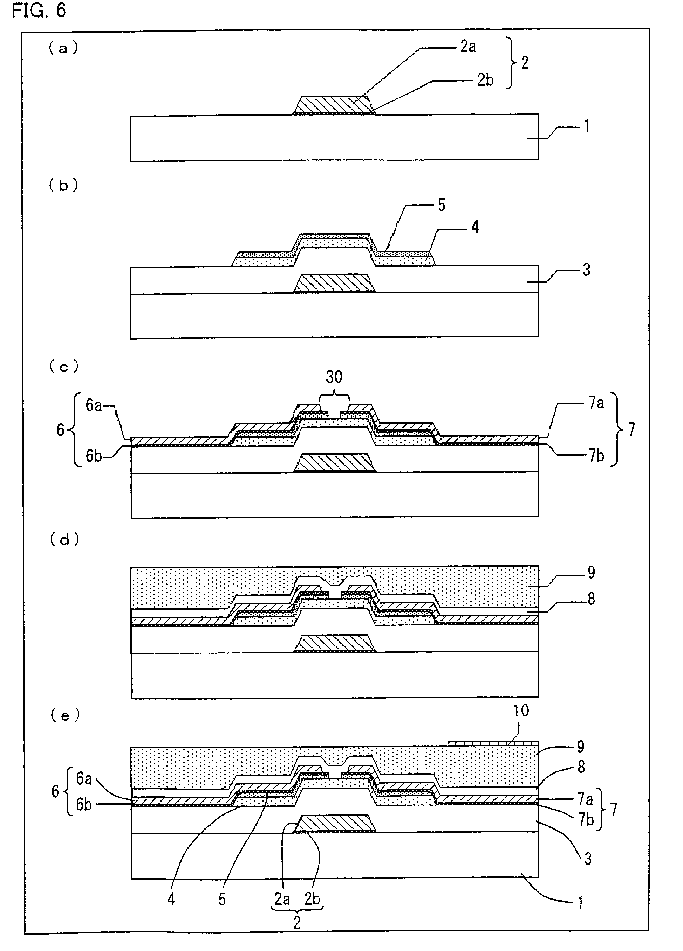

   Fig. 6 is a drawing showing (i) how an active matrix substrate is configured in a display region and (ii) a method for manufacturing the active matrix substrate.
Fig. 7
   Fig. 7 is a drawing showing (i) how a counter substrate is configured in the display region and (ii) a method for manufacturing the counter substrate.
Fig. 8
   Fig. 8 is a drawing showing how a connecting terminal of a conventional technique is configured.
Fig. 9
   Fig. 9 is a drawing showing how a connecting terminal of another conventional technique is configured.
Fig. 10
   Fig. 10 is a drawing showing a situation in which a TCP (Tape Carrier Package) is connected to the connecting terminal of the conventional technique.

### Description of Embodiments

Embodiments of the present invention are described in detail below with reference to the drawings. Note that, although the following description explains a variety of limitations which are suitable in view of realization of the present invention, the technical scope of the present invention is not limited to descriptions in the following Examples and drawings.

Note also that all of the drawings schematically show respective articles so as to clarify their structures. Some constituents are more exaggerated in size than others are, so that relationships between their actual sizes are not shown in any of the drawings. Note further that, in Figs. 1 through 7, members identical between Figs. 1 through 7 are given identical reference numerals. Principally, explanation of such identical members is not repeatedly given for each of Figs. 1 through 7.

### Example 1

Example 1 of the present invention is described with reference to Figs. 1, 2, and 6.
Fig. 1 is a drawing showing (i) a connecting terminal of the present invention and (ii) a liquid crystal display apparatus of the present invention which employs the connecting terminal of the present invention. (a) of Fig. 1 is a cross sectional view taken on the line (i-i) in (c) of Fig. 1 and the line (g-g) in (b) of Fig. 1. (b) of Fig. 1 is a cross sectional view taken on the line (f-f) in (a) of Fig. 1 and the line (h-h) in (c) of Fig. 1(c) of Fig. 1 is a plan view showing a connecting terminal part. (d) of Fig. 1 is a view showing an effect brought about by the present invention. (e) of Fig. 1 is a view showing a state that a TCP is connected to the connecting terminal part of the present invention.
Fig. 2 is a drawing showing a method for manufacturing (i) the connecting terminal of the present invention and (ii) the liquid crystal display apparatus of the present invention which employs the connecting terminal of the present invention. Fig. 6 is a drawing showing a method for manufacturing an active device, for example, a TFT, which is provided in a display region (active area) located in an inward part of the liquid crystal display apparatus. As later described, the connecting terminal of the present invention can be manufactured at the same time as the active device is manufactured. For this reason, members identical between Figs. 1, 2, and 6 are given identical reference numerals. As such, by comparing Figs. 2 and 6, it is possible to understand how the connecting terminal of the present invention and the active device are manufactured.

In (a) of Fig. 1 through (e) of Fig. 1, 1 indicates a first substrate made from glass etc. A first line 2 (lower layer line) is provided on a substrate 1. The first substrate 1 has a part roughly divided into a part where a connecting terminal 20 is provided and a part where a display region 21 is provided. An active device, such as a TFT, is provided in the display region 21 of the first substrate 1. As such, the first substrate 1 is used as an active matrix substrate in a display apparatus such as a liquid crystal display apparatus. The first substrate 1 is electrically connected to an outside via the connecting terminal 20.

An insulating layer 3 is provided on the first line 2. Further, a second line 6 (upper layer line) is provided on the insulating layer 3. Each of the first line 2 and the second line 6 may be a Cu line whose water resistance property is relatively low. For improvements in adhesiveness and barrier property to a substrate or the like, it is preferable that each of the first line 2 and the second line 6 has a bi-layer structure made up of (i) a lower layer line which is made from Ti etc. and (ii) an upper layer line which is made from Cu and provided above the lower layer line. This is later described in detail with reference to Fig. 2. Note, however, that neither a configuration of the first line 2 nor that of the second line 6 is necessarily limited to this configuration. Alternatively, each of the first line 2 and the second line 6 can have a layered structure made up of (i) a layer made from copper or a copper alloy and (ii) a layer made from titanium, a titanium compound, molybdenum, or a molybdenum compound.

According to the present example, the first line 2 is used as a scanning line via which a scanning signal is supplied to the active device. That is, the first line 2 is a line for use in activation of a pixel electrode (transparent pixel electrode). On the other hand, the second line 6 is a used as a signal line via which an image signal is supplied to the pixel electrode via the active device.

8 indicates a protective layer provided after the second line 6 has been provided. As later detailed with reference to Fig. 2, a protective layer 8 is provided on the entire connecting terminal part which includes the second line 6, and then, removed by photolithography and etching techniques in regions corresponding to end parts 15 and 16 of the first line 2, a center part 17 of the second line 6, and an end part 11 of the display region 21. This causes a surface of the first line 2 and that of the second line 6 to be exposed in the respective corresponding regions. An opening is provided in the protective layer 8, the insulating layer 3, etc. in the region corresponding to the end part 11 of the display region 21. The opening serves as a contact hole for the first line 2 and the second line 6 and is therefore hereinafter referred to as a contact hole 11.

10 indicates a transparent conductive thin film made from ITO etc. A transparent conductive thin film 10 is provided so as to be in direct contact with (i) the first line 2 in "regions where the respective end parts 15 and 16 of the first line 2 are exposed", (ii) the second line 6 in "a region where the center part 17 of the second line 6 is exposed", and (iii) the first line 2 and the second line 6 in the contact hole 11 in which the first line 2 and the second line 6 are exposed. The first line 2 and the second line 6 are thus electrically connected to each other via the transparent conductive thin film 10 such as ITO. It is clear that the first line 2 and the second line 6 are therefore connected to each other in parallel in the connecting terminal 20. The transparent conductive thin film 10 is deposited and provided at the same time as the pixel electrode is provided in the display region. A configuration thus described allows for increased number of connection parts between the first line 2 and the second line 6. With the configuration, it is therefore possible to further reduce a risk of disconnection in the connecting terminal 20.

Instead of the center part 17, an end part of the second line 6 may be exposed. In this case, the transparent conductive thin film 10 is provided so as to be in direct contact with (i) the first line 2 in "the regions where the respective end parts 15 and 16 of the first line 2 are exposed" and (ii) the second line 6 in "a region where the end part of the second line 6 is exposed". Even such a configuration allows for increased number of connection parts between the first line 2 and the second line 6. With the configuration, it is therefore possible to further reduce a risk of disconnection in the connecting terminal 20.

13 indicates a second substrate (color filter substrate) in which a color filter etc. are provided in the display region 21. A substrate 13 is provided so as to face the substrate 1. The substrates 13 and 1 are attached to each other via a sealing member 12. Note that a liquid crystal is introduced in a space 14 between the substrates 1 and 13.

As early described, the transparent conductive thin film 10 is provided at the same time as the pixel electrodes are provided generally in the display region 21. This poses a limitation that, in order for a pixel electrode part to secure a transparency, a thickness of the transparent conductive thin film 10 cannot be so thick. Thus, it is difficult to completely remove a risk that the transparent conductive thin film 10 has a defect such as a pinhole.

As shown in (d) of Fig. 1, in a case where the transparent conductive thin film 10 has a defect 22, such as a pinhole, in a region corresponding to the end part 15 of the first line 2, the first line 2 may be corroded due to moisture in the air. 23 indicates a corrosion part of the first line 2. If a corrosion part 23 is so expanded that the entire end part 15 of the line 2 is corroded, electric connection between the end part 15 of the first line 2 and the second line 6 is "disconnected".

Even in such an event, the connecting terminal 20 of this invention enables maintaining electric connection between the first line 2 and the second line 6 via the transparent conductive thin film 10 in (i) a region corresponding to the opposite end part 16 of the first line 2 and (ii) the contact hole 11. This ensures supply of power to the active device etc. provided in the display region 21 via the first line 2. A probability that the transparent conductive thin film 10 has two or more pinholes in the single connecting terminal part is very low. Consequently, a probability that the electric connection between the first line 2 and the second line 6 is "disconnected" is very low. It is clear that the connecting terminal configured as such thus has a highly reliable connecting terminal structure. Further, even if (i) an end part of the line 2 or 6 and the transparent conductive thin film has a pinhole, and (ii) the end part of the line 2 or 6 is corroded increasingly in a line width direction so as to be disconnected, the other end parts of the respective lines 2 and 6 are still connected to the transparent conductive thin film. It is therefore possible to prevent an entire terminal from being disconnected.

(e) of Fig. 1 shows a state that a TCP is connected to the connecting terminal 20. In (e) of Fig. 1, 24 indicates a TCP including a connecting electrode 25. The TCP is attached onto the transparent conductive thin film 10 by an anisotropic conductive adhesive agent 26 in the center part 17.

It is shown in (a) of Fig. 1 that the contact hole 11 is located at a region corresponding to the display region 21 (located inwardly of a sealing surface). Note, however, that the contact hole 11 can be located at a region corresponding to the connecting terminal 20. In a case where the contact hole 11 is located at a region corresponding to the display region 21, Cu is less likely to be corroded by moisture. However, according to the present invention, even in a case where the contact hole 11 is located at a region corresponding to the connecting terminal 20, it is still possible for the connecting terminal to have a sufficient reliability.

The following description explains a method for manufacturing the connecting terminal of Example 1 of the present application. The connecting terminal described in Example 1 of the present application is manufactured at a same time as the active device, such as a TFT, is formed in the display region. At first, a method for forming the active device in the display region is described with reference to Fig. 6. Then, a method for manufacturing the connecting terminal described in Example 1 is described with reference to Fig. 2. In Figs. 6 and 2, members identical between Figs. 6 and 2 are given identical reference numerals. As such, by comparing Figs. 6 and 2, it is possible to clearly understand that the connecting terminal of Example 1 is manufactured at the same time as the TFT is formed.

(a) through (e) of Fig. 6 sequentially show steps of the method for forming the active device.

At first, the substrate 1 that is made from glass etc. is prepared. Then, a Ti film is formed on the substrate 1. Then, a Cu film is formed on the Ti film. The Ti film, which serves as a lower layer, has a thickness of 20 nm to 150 nm. The Cu film, which serves as an upper layer, has a thickness of approximately 200 nm to 500 nm. Bi-layer film thus made up of the Ti film and the Cu film is patterned by carrying out photolithography, wet-etching, and resist removal and cleaning to form the first line 2 which is made up of a first lower layer line 2b and a first upper layer line 2a. The first line 2 serves as a scanning line via which a scanning signal is supplied to the TFT (see (a) of Fig. 6).

The insulating layer 3 is formed on the substrate 1 on which the first line 2 has been formed (see (b) of Fig. 6). Then, amorphous Si layers to constitute a channel layer 4 and an electrode contact layer 5 are formed on the insulating layer 3. Specifically, the following (i) through (iii) are formed by a CVD method: (i) an SiNx layer that has a thickness of 200 nm to 500 nm and serves as the insulating layer 3, (ii) the amorphous Si layer that has a thickness of 30 nm to 300 nm and serves as the channel layer, and (iii) N⁺ amorphous Si that has a thickness of 20 nm to 150 nm and serves as the electrode contact layer 5 to which a high concentration of an n-type dopant is added; and then the electrode contact layer and the channel layer are patterned by carrying out photolithography, dry etching, and resist removal and cleaning (see (b) of Fig. 6).

Subsequently, another bi-layer film made up of a Ti film and a Cu film is formed on the insulating layer 3 and the electrode contact layer 5, and then treated by etching etc. for formation of the TFT. Specifically, (i) the Ti film, which is a lower layer of the bi-layer film and has a thickness of 20 nm to 150 nm, and (ii) the Cu film, which is an upper layer of the bi-layer film and has a thickness of 200 nm to 500 nm, are deposited by a sputtering method. Then, the Ti film and the Cu film are patterned by carrying out photolithography, wet etching, and resist removal and cleaning to form a signal line 6 and a drain line 7, each of which is made up of the Cu/Ti film. Further, the N⁺ amorphous Si is removed by dry etching in a channel section 30 until the channel layer 4 is exposed (see (c) of Fig. 6), which channel section 30 is located at a region corresponding to an approximate center of the electrode contact layer 5.

As clearly shown in (c) of Fig. 6, the signal line 6 is made up of (i) a lower layer line 6b made from the Ti film and (ii) an upper layer line 6a made from the Cu film. Similarly, the drain line 7 is made up of (i) a lower layer line 7b made from the Ti film and (ii) an upper drain line 7a made from the Cu film.

After the signal line 6 and the drain line 7 are thus formed, the protective layer 8 and the interlayer insulating layer 9 are formed on the signal line 6 and the drain line 7 (see (d) of Fig. 6). An SiNx film which has a thickness of 100 nm to 700 nm is deposited by the CVD method. Then, a photosensitive interlayer insulating film material is coated, and patterned by photolithography. Subsequently, the protective layer 8 and the insulating layer 3 are patterned by dry etching. Note that, unlike a resist, the photosensitive interlayer insulating material is not removed. Therefore, the patterned photosensitive interlayer insulating material is left above the substrate.

After this, the transparent conductive thin film 10 which is made from ITO etc. is formed on the interlayer insulating film 9 and then patterned by a photolithography technique to have a predetermined shape, so that a pixel electrode is formed. Specifically, an ITO film which has a thickness of 50 nm to 200 nm is deposited by the sputtering method, and then patterned by photolithography, wet etching, resist removal and cleaning to form the pixel electrode that is made from an ITO film. The first substrate in which a plurality of active devices are provided in matrix is referred to as an active matrix substrate (see (e) of Fig. 6).

As early described, the deposited Ti film and Cu film are patterned to have a predetermined shape so that they serve as each of the signal line 6 and the drain line 7 as shown in (c) of Fig. 6. The signal line 6 is drawn out from the display region 21 to the connecting terminal 20.

With reference to Fig. 2, the following description explains the method for manufacturing the connecting terminal of Example 1. The connecting terminal is formed at the same time as the first substrate (the active matrix substrate), which is thus described with reference to Fig. 6, is manufactured. As such, descriptions of (i) how layers are deposited, (ii) thicknesses of the respective layers, and (iii) how the respective layers are patterned are omitted here. Note that such descriptions of (i) through (iii) are likely omitted in Examples 2 through 4.

At first, the Ti film (which is the first lower layer line 2b) is formed on the first substrate 1 which is made from glass etc. Then, the Cu film (which is the first upper layer line 2a) is formed on the Ti film. After this, the Ti film and the Cu film are patterned so that the first line 2 that has a bi-layer structure is formed. As already described, the first line 2 is formed at the same time as the first line 2 which is shown in Fig. 6 is formed (see (a) of Fig. 2).

Subsequently, the insulting layer 3 is formed on the first line 2. Then, the channel layer 4 and the electrode contact layer 5 are formed on the insulating layer 3. Note that the channel layer 4 and the electrode contact layer 5 are removed by etching in the connecting terminal part of Example 1 (see (b) of Fig. 2).

Then, another bi-layer film made up of the Ti film and the Cu film is formed on the insulating layer 3 and patterned by photolithography to have a predetermined shape, so that the second line 6 is formed. As already described, the second line 6 is formed at the same time as the second lower layer line 6b, the second upper layer line 6a, the second lower layer line 7b, and the second upper layer line 7a, each of which is described with reference to Fig. 6, are formed (see (c) of Fig. 2).

Subsequently, the protective layer 8 is formed on an entire surface. Then, layers are removed so that the end parts 15 and 16 of the first line 2 and the center part 17 of the second line 6 are exposed. After this, the interlayer insulating film 9 is formed on an entire surface. Then, the interlayer insulating film 9 is completely removed in the connecting terminal part. After this, the transparent conductive thin film 10 that is made from ITO etc. is formed and patterned to have a predetermined shape (see (e) of Fig. 2), at the same time as the pixel electrode is formed in the display region.

The connecting terminal, in which the first line 2 and the second line 6 are electrically connected to each other via the transparent conductive thin film 10, is thus formed.

Note that the connecting terminal 20 of the present example can have either of a configuration in which no interlayer insulating film 9 is provided and a configuration in which an interlayer insulating film 9 is provided.

### Example 2

Example 2 of the present invention is explained with reference to Fig. 3. According to Example 2, unlike Example 1, a channel layer 4 and an electrode layer 5 are left in a connecting terminal part. A configuration other than this is identical with the configuration of the connecting terminal of Example 1, and is thereby briefly explained below.

At first, as shown in (a) of Fig. 3, a first line 2 is formed on a glass substrate 1. Then, as shown in (b) of Fig. 3, an insulating layer 3, a channel layer 4, and an electrode contact layer 5 are formed to have a predetermined shape as a result of patterning by a photolithography technique. Further, the channel layer 4 and the electrode contact layer 5 are removed, in regions corresponding to respective end parts 15 and 16 of the first line 2, until the insulating layer 3 is exposed. Contact holes that are bored to the insulating layer 3 are thus formed.

Subsequently, a second line 6 that has a predetermined shape is formed on the electrode contact layer 5, as shown in (c) of Fig. 3. Then, the insulating layer 3 etc. are removed by etching so that the contact holes, which are located in the respective regions corresponding to the respective end parts 15 and 16 of the first line 2, are bored to the first line 2 (see (d) of Fig. 3). Then, as shown in (e) of Fig. 3, a transparent conductive thin film 10 that is made from ITO etc. is formed at the same time as the pixel electrode is formed in a display region, and at the last step of the process, the transparent conductive thin film 10 is patterned to have a predetermined shape (see (e) of Fig. 3).

In the case of Example 2, the contact layer 5 and the channel layer 4 are used as a part of a line layer. Such a configuration is suitable in view of obtaining of a line having a required electric conductivity. Even though no configuration in the display region is shown, Examples 2 has a configuration similar to that of Example 1. As such, detailed description of it is omitted here.

Note that the connecting terminal 20 of the present example can have either of a configuration in which no interlayer insulating film 9 is provided and a configuration in which an interlayer insulating film 9 is provided.

### Example 3

Example 3 of the present invention is explained with reference to (a) through (d) of Fig. 4. (a) of Fig. 4 is a cross sectional view taken on the line (k-k) in (c) of Fig. 4 later described. (b) of Fig. 4 is a cross sectional view taken on the line (j-j) in (a) of Fig. 4 and the line (m-m) in (c) of Fig. 4. (c) of Fig. 4 is a plan view showing a connecting terminal part. (d) of Fig. 4 is a view showing an effect brought about by the present invention. As early described, the connecting terminal part of Example 3 is formed at the same time as an active device such as a TFT, which is described with reference to Fig. 6, is formed in a display region. For this reason, members formed in steps identical with the steps in which the members shown in Fig. 6 are formed are given identical reference numerals.

It is shown in (a) through (c) of Fig. 4 that a first line 2 is provided on a glass substrate 1, an insulating layer 3 is provide on the first line 2, and a second line 6 is provided on the insulating layer 3. As clearly shown in (b) and (c) of Fig. 4, in the case of Example 3, the first line 2 diverges into three lines in a connecting terminal 20, whereas the second line 6 diverges into two lines in the connecting terminal 20 so that two divergent lines of the second line 6 are located between three divergent lines of the first line 2. That is, each of the first line 2 and the second line 6 diverges into a plurality of lines. Obviously, neither the number of the divergent lines of the first lines 2 nor the number of the divergent lines of the second line 6 is limited to the number shown in Fig. 4.

As clearly shown in (b) of Fig. 4, the three divergent lines of the first line 2 and the two divergent lines of the second line 6 are connected to each other via a transparent conductive thin film 10 made from ITO etc. Further, the first line 2 and the second line 6 are connected to each other in a contact hole 11 in a display region 21. Note that 8 indicates a protective layer.

According to the present example, it is possible to secure the increased number of connecting parts between the first line 2 and the second line 6. With such a configuration, it is possible to provide a connecting terminal whose reliability is high. The contact hole 11 is located in the display region 21. However, instead of being provided in the display region 21, the contact hole 11 can be provided in the connecting terminal 20. This is similar to the case of Example 1.

(d) of Fig. 4 shows a case that a part of the transparent conductive thin film 10 such as ITO has a defect so that metal corrosion occurs due to moisture in the air. Even in a case where a center one of the three divergent lines of the first line 2 is corroded to be disconnected, electric connection between the connecting terminal 20 and the display region are achieved by remaining two of the three divergent lines of the first line 2. A probability that all of the three divergent lines of the first line 2 are corroded is very small. With the configuration of Example 3 of the present invention, it is therefore possible to provide a connecting terminal whose reliability is high.

### Example 4

Example 4 of the present invention is explained with reference to Fig. 5. Example 4 describes how a connecting terminal to a second line 6 is configured, whereas each of Examples 1 through 3 describes how the connecting terminal to the first line 2 is configured. Fig. 5 is a view corresponding to (a) of Fig. 1. In Fig. 5, members identical with the members shown in (a) of Fig. 1 are given identical reference numerals. There is no plan view corresponding to (c) of Fig. 1. As described below, Example 4 is different solely in terms of a configuration in a display region 21, but identical in terms of how a connecting terminal 20 is configured.

In Fig. 5, 1 indicates a substrate made from glass etc. A first line 2 is provided on the glass substrate. An insulating layer 3 is provided on the first line 2. A second line 6 is provided on the insulating layer 3. The first line 2 and the second line 6 are electrically connected to each other via a transparent conductive thin film 10 in a contact hole 11 located in the display region 21. That is, the first line 2 is connected to parts of the second line 6 via the contact hole 11; one of which parts is closer to the connecting terminal 20 and the other of which parts is closer to the display region 21. The first line 2 is disconnected in a region 31. Note that 8 indicates a protective layer, 12 indicates a sealing member, and 13 indicates a second substrate. Although Fig. 5 lacks a cross sectional view showing the connecting terminal 20 of Example 4, the connecting terminal 20 of Example 4 can have a configuration similar to the configurations of the connecting terminals 20 of Examples 1 through 3.

According to Example 4, it is possible to provide a connecting terminal whose reliability is high, which connecting terminal is provided for drawing out the second line 2 in the display region, that is, a signal line provided in an active matrix substrate, off the display region.

Examples 1 through 4 above describe that each of the first layer 2 and the second layer 6 has a bi-layer structure consisting of the Cu layer and the Ti layer. Note, however, that, instead of the Ti layer which serves as the lower layer, Mo, an Mo alloy, or the like can be used. Also, although amorphous Si is used to form the channel layer, an oxide semiconductor such as µc-Si, ZnO, or IGZO can be used to replace amorphous Si.

At last, the following description explains (i) how the second substrate is configured and (ii) a method for manufacturing the second substrate. Fig. 7 is a drawing showing (i) how the second substrate is configured and (ii) the method for manufacturing the second substrate. The following description deals with a liquid crystal display apparatus as an example. In (a) of Fig. 7, a second substrate 13 is a substrate in which a color filter is provided. The second substrate 13 is therefore referred to as a color filter substrate. According to the present example, (i) a black matrix 72 and (ii) red, green, and blue color filters 73 are formed, by use of a photosensitive material, by a photolithography technique. Then, as shown in (b) of Fig. 7, a common electrode 74 is formed. According to the present example, the common electrode 74 is formed by (i) depositing an ITO film of a thickness of 50 nm to 200 nm by a sputtering method and then (ii) patterning the ITO film by photolithography and etching. At a last step of the method, photo spacers 75 are formed as shown in (c) of Fig. 7. For example, the photo spacers 75 are formed, by use of a photosensitive material, by the photolithography technique.

Alignment films made from polyimide are formed, by printing, on respective of the first substrate and the second substrate thus manufactured. Subsequently, sealing agent printing and ODF (one drop fill) are carried out. Then, the first substrate and the second substrate are combined to each other, and the resultant is diced to manufacture individual liquid crystal display apparatuses.

The present invention is not limited to any of the embodiments thus described. The present invention can be varied in many ways within the scope of the claims by one skilled in the art. That is, by combining technical means properly modified within the scope of the claims, it is possible to obtain a new embodiment.

In order to attain the object, a connecting terminal of another invention of the present application is configured so that the lower layer line and the upper layer line are connected to each other via a transparent conductive thin film by connecting an end part of the lower layer line and a center part of the upper layer line.

According to the configuration, it is possible to secure the increased number of connecting parts between the lower layer line and the upper layer line. It is therefore possible to reduce a risk of disconnection in a connecting terminal part.

In order to attain the object, a connecting terminal of still another invention of the present application is configured so that the lower layer line and the upper layer line are connected to each other via the transparent conductive thin film by connecting a center part of the lower layer line and an end part of the upper layer line.

According to the configuration, it is possible to secure the increased number of connection parts between the lower layer line and the upper layer line. It is therefore possible to reduce a risk of disconnection in a connecting terminal part.

In order to attain the object, a connecting terminal of yet another invention of the present application is configured so that the lower layer line and the upper layer line are connected to each other via the transparent conductive thin film in a contact hole.

According to the configuration, it is possible to relatively easily connect an upper layer electrode and a lower layer electrode. Each of the upper layer line and lower layer line is connected to an external terminal connecting electrode (ITO). As such, even in a case where either one of the upper layer line and the lower layer line is disconnected, the other one of the upper layer line and the lower layer line can remain conductive. It is therefore possible to prevent a terminal as a whole from being disconnected.

In order to attain the object, a connecting terminal of yet another invention of the present application is configured so that the contact hole is located inwardly of a sealing surface in the display apparatus.

According to the configuration, the contact hole is thus provided inwardly of the sealing surface of the display apparatus. It is therefore possible to greatly reduce a risk that the lines are corroded by moisture in the air on the inward side of the sealing surface.

In order to attain the object, a connecting terminal of yet another invention of the present application is configured so that one or both of the upper layer line and the lower layer line diverge into respective plurality of lines in a connecting terminal part.

According to the configuration, it is possible to secure the increased number of connecting parts between the upper layer line and the lower layer line via the transparent conductive thin film. It is therefore possible to obtain a further improved reliability in the connecting terminal part.

In order to attain the object, a connecting terminal of yet another invention of the present application is configured so that: each of the upper layer line and the lower layer line has a layered structure made up of (i) a layer made from copper or a copper alloy and (ii) a layer made from titanium, a titanium compound, molybdenum, or a molybdenum compound; and the transparent conductive thin film is made from ITO.

According to the configuration, copper or the copper alloy with greater conductivity is used. It is therefore possible to provide a connecting terminal which is highly reliable and suitable for miniaturization of the connecting terminal part.

In order to attain the object, a connecting terminal of yet another invention of the present application is configured so that a display apparatus includes any of the connecting terminals described above.

According to the configuration, it is therefore possible to provide a display apparatus including the connecting terminal which is highly reliable.

In order to attain the object, a connecting terminal of yet another invention of the present application is configured so that the substrate of the display apparatus is an active matrix substrate.

According to the configuration, it is possible to provide a connecting terminal in a display apparatus including the active matrix substrate whose connecting terminal has an improved reliability.

In order to attain the object, a connecting terminal of yet another invention of the present application is configured so that the display apparatus is a liquid crystal display apparatus.

According to the configuration, it is therefore possible to provide a liquid crystal display apparatus whose connecting terminal section has an improved reliability.

The invention being thus described, it will be obvious that the same way may be varied in many ways. Such variations are not to be regarded as a departure from the spirit and scope of the invention, and all such modifications as would be obvious to one skilled in the art are intended to be included within the scope of the following claims.

### Industrial Applicability

The present invention can be applied to a connecting terminal for use in connecting of a display apparatus, such as a liquid crystal display apparatus, or the like to an external apparatus.

### Reference Signs List

- 1.: first substrate (glass substrate)
- 2.: first line (lower layer line)
- 3.: insulating layer
- 4.: channel layer
- 5.: electrode contact layer
- 6.: second line (upper layer line)
- 7.: drain electrode
- 8.: protective layer
- 9.: interlayer insulating layer
- 10.: transparent conductive thin film
- 11.: contact hole
- 12.: sealing member
- 13.: second substrate
- 20.: connecting terminal
- 21.: display region
- 24.: TCP
- 25.: electrode
- 26.: anisotropic conductive adhesive agent

## Claims

1. A connecting terminal in a substrate of a display apparatus including (i) a lower layer line and (ii) an upper layer line located above the lower layer line via an insulating layer, via which connecting terminal the lower layer line and the upper layer line are connected to an outside the substrate of the display apparatus, a transparent pixel electrode being driven via the lower layer line,
the lower layer line and the upper layer line being connected to each other via a transparent conductive thin film constituting the transparent pixel electrode.

2. The connecting terminal as set forth in Claim 1, wherein:
the lower layer line and the upper layer line are connected to each other via the transparent conductive thin film, by connecting an end part of the lower layer line and a center part of the upper layer line.

3. The connecting terminal as set forth in Claim 1, wherein:
the lower layer line and the upper layer line are connected to each other via the transparent conductive thin film, by connecting a center part of the lower layer line and an end part of the upper layer line.

4. The connecting terminal as set forth in any one of Claims 1 through 3, wherein:
the lower layer line and the upper layer line are connected to each other via the transparent conductive thin film in a contact hole.

5. The connecting terminal as set forth in Claim 4, wherein:
the contact hole is located inwardly of a sealing surface in the display apparatus.

6. The connecting terminal as set forth in any one of Claims 1 through 5, wherein:
one or both of the upper layer line and the lower layer line diverge into respective plurality of lines in a connecting terminal part.

7. The connecting terminal as set forth in any one of Claims 1 through 6, wherein:
each of the upper layer line and the lower layer line has a layered structure made up of (i) a layer made from copper or a copper alloy and (ii) a layer made from titanium, a titanium compound, molybdenum, or a molybdenum compound; and
the transparent conductive thin film is made from ITO.

8. A display apparatus, comprising a connecting terminal as set forth in any one of Claims 1 through 7.

9. The display apparatus as set forth in Claim 8, wherein the substrate of the display apparatus is an active matrix substrate.

10. The display apparatus as set forth in Claim 9, wherein the display apparatus is a liquid crystal display apparatus.
